# EUROPÄISCHE PATENTSCHRIFT

(11) **EP 3 771 875 B1**
(45) Veröffentlichungstag und Bekanntmachung des Hinweises auf die Patenterteilung: **03.07.2024**
(21) Anmeldenummer: 20188295.8
(22) Anmeldetag: 29.07.2020
(51) Int. Cl.: F27B 9/30, B23K 1/008, B23K 1/012, F27B 9/40, F27D 1/18, F27D 19/00, F27D 21/00, B23K 3/047, B23K 3/08

(54) **MECHATRONISCHER VORHANG FÜR EINE PROZESSKAMMER ZUR DURCHFÜHRUNG THERMISCHER PROZESSE IN DER FERTIGUNG ELEKTRONISCHER BAUGRUPPEN**
MECHATRONIC CURTAIN FOR A PROCESS CHAMBER FOR CARRYING OUT THERMAL PROCESSES IN THE MANUFACTURE OF ELECTRONIC ASSEMBLIES
RIDEAU MÉCATRONIQUE POUR UNE CHAMBRE DE PROCESSUS DESTINÉ À LA MISE EN UVRE DES PROCESSUS THERMIQUES LORS DE LA FABRICATION DE MODULES ÉLECTRONIQUES

(30) Priorität: 29.07.2019 DE 102019211212
(43) Veröffentlichungstag der Anmeldung: 03.02.2021
(73) Patentinhaber: Rehm Thermal Systems GmbH, 89143 Blaubeuren-Seissen (DE)
(72) Erfinder: Wild, Paul, 89143 Blaubeuren-Seissen (DE)
(74) Vertreter: Grünecker Patent- und Rechtsanwälte PartG mbB

(56) Entgegenhaltungen:
- WO-A1-2007/088695

## Beschreibung

### Gebiet der Erfindung

Die vorliegende Erfindung betrifft Vorrichtungen zur Durchführung thermischer Prozesse in der Fertigung elektronischer Baugruppen. Insbesondere betrifft die vorliegende Erfindung eine Prozesskammer gemäß dem Oberbegriff des Anspruches 1.

### Stand der Technik

Bei der Fertigung elektronischer Baugruppen finden diverse thermische Prozesse, wie beispielsweise Löten, Trocknen und Funktionstest bei hohen und tiefen Temperaturen statt. Zur Vermeidung von Oxidation oder Vereisung während des thermischen Prozesses wird die Prozesskammer mit Schutzgas, einem inerten Gas wie beispielsweise Stickstoff, kontinuierlich oder getaktet geflutet.

In typischen Anlagen zur Fertigung von elektronischen Baugruppen, wie sie z.B. in der WO 2007/088695 A1 beschrieben wird, werden die Baugruppen automatisch von einer Prozessstation zur nächsten transportiert. Beispielsweise wird eine Leiterplatte nach ihrer Fertigung in einer Prozessstation mit einem Lötstopplack versehen und getrocknet. Danach wird die Leiterplatte in einer weiteren Prozessstation mit Lötpaste beschichtet und in einer nachfolgenden Prozessstation mit Bauelementen bestückt. Danach wird die bestückte Leiterplatte zur Reflow-Lötprozessstation und anschließend zu einer Station weitergeleitet, wo die elektronische Baugruppe mit einem Schutzlack beschichtet wird. Anschießend können Funktionstests beispielsweise bei tiefen und hohen Temperaturen durchgeführt werden. Die einzelnen Stationen sind dabei keine hermetisch abgeschlossenen Bereiche, in denen eine Schutzgasatmosphäre permanent gehalten wird. D. h. die Prozessstationen sind offen, um den Arbeitsfluss nicht zu behindern. Es bedeutet auch, dass die Schutzgasatmosphäre sich verflüchtigt und die Konzentration der Schutzgasatmosphäre am Prozessort nur aufrechterhalten werden kann, wenn ständig Schutzgas zugeführt wird.

Bei den Anlagen nach dem getaktetem und insbesondere nach dem Durchlaufprinzip müssen die Werkstücke in die Prozesskammer gebracht und herausgebracht werden. Dafür muss die Prozesskammer über entsprechende Öffnungen an und in der Kammer verfügen. Durch diese Öffnungen kommt es zum Ausströmen und damit einem Verlust des inerten Gases. Um das zu vermeiden, wird der Querschnitt dieser Öffnungen durch entsprechende Vorrichtung zum Verkleinern der Öffnung, wie beispielsweise Vorhänge, Faltbälge, Schiebeklappen etc., verkleinert.

Verwendung finden dabei beispielsweise Lamellenvorhänge mit einer Vielzahl von herabhängenden und von unten nach oben stehenden Lamellen, die aus einem mit leitfähigen Kunststoff laminierten Gewebe bestehen, das beispielsweise bis 160 °C temperaturstabil ist. Die Lamellen sind so steif, dass die von unten nach oben stehenden Lamellen nicht zusammenfallen. Die Lamellen im Einlauf der Prozesskammer sind so ausgelegt, dass sie den Öffnungsquerschnitt einer Prozesskammer auf die größte Querschnittsfläche der zuzuführenden Baugruppen verkleinern. Im Auslauf der Prozesskammer liegen die oberen und unteren Lamellen aufeinander, d.h. überlappen. Die Lamellen sind jedoch flexibel genug, dass sie sich zur Seite biegen, wenn eine Baugruppe durch die Öffnung geführt wird.

Ein Nachteil dieser Methode im Einlauf und Auslauf besteht darin, dass diese den Querschnitt nur mit einem bestimmten Abstand zu den durchlaufenden Werkstücken reduzieren, wodurch immer noch relativ viel Schutzgas entweichen kann. Wird der Abstand zu groß gewählt, entweicht zu viel Schutzgas. Wird der Abstand zu klein gewählt, können Bauteile auf der Baugruppe verschoben werden und zusätzlich entsteht zu viel Abrieb und Verschleiß und damit Verschmutzung, wenn die Bauteile die Lamellen berühren oder verbiegen.

Es wird also ein Kompromiss angestrebt zwischen Verlust von Schutzgas, Schutz der Baugruppen vor dem Verschieben von Komponenten und Verschleiß. Durch den "Sicherheitsabstand" zwischen der Oberfläche der Baugruppe und den Lamellen verbleibt eine Nettoöffnungsfläche, durch die Schutzgas entweichen kann, die der Differenz aus der durch die Lamellen verkleinerten Öffnungsfläche und der Baugruppenquerschnittsfläche entspricht. Passiert keine Baugruppe die Öffnung entspricht die Öffnungsfläche, durch die Schutzgas entweichen kann, der Nettoöffnungsfläche, die größer ist als die Differenzfläche. D. h., während der Durchführung des Wärmeprozesses, wenn keine Baugruppe die Öffnung passiert, entweicht mehr Schutzgas.

Es ist deshalb eine Aufgabe der vorliegenden Erfindung, eine Vorrichtung für eine Prozesskammer bereitzustellen, die den Querschnitt der Öffnung flexibel und effizient verringert, so dass weniger Schutzgas entweichen kann.

### Zusammenfassung

Die vorliegende Aufgabe wird erfüllt durch eine Prozesskammer gemäß Anspruch 1. Die Prozesskammer ist zur Durchführung thermischer Prozesse in der Fertigung einer elektronischen Baugruppe ausgelegt, wobei die Prozesskammer Folgendes umfasst: mindestens eine Öffnung zum Einbringen und/oder Herausnehmen der elektronischen Baugruppe und eine Einrichtung zum Zuführen eines Schutzgases. Die Prozesskammer ist gekennzeichnet durch eine steuerbare Schutzeinrichtung, die an der Öffnung angeordnet ist, um ein Entweichen von Schutzgas aus der Prozesskammer zu verringern; und durch eine Steuerungseinrichtung, die die Schutzeinrichtung so steuern kann, dass, wenn die elektronische Baugruppe die Öffnung passiert, ein Öffnungsquerschnitt der Öffnung bereitgestellt wird, der mit dem Querschnitt der elektronischen Baugruppe korrespondiert.

Die Öffnung der Prozesskammer wird mit der steuerbaren Schutzeinrichtung so gesteuert, dass sie individuell an die Baugruppen Topografie angepasst wird, sodass die Fläche, durch die Schutzgas entweichen kann, minimiert wird. Im Stand der Technik werden Lamellenvorhänge verwendet, um den Öffnungsquerschnitt zu verkleinern. Die Lamellenvorhänge können jedoch nicht gesteuert werden. Die flexiblen Lamellen erlauben zwar eine Variabilität des Baugruppenquerschnitts, sind aber nicht in der Lage, den Öffnungsquerschnitt individuell je nach Baugruppe zu minimieren.

In dieser Ausführungsform umfasst die Prozesskammer weiterhin eine Messeinrichtung, die die Topografie der elektronischen Baugruppe erfasst. Die Messeinrichtung ist vorteilhafter Weise an einer Stelle der Prozesskammer angeordnet, wo die Topographie der elektronischen Baugruppe erfasst werden kann, bevor sie die Öffnung passiert. Dabei ist die Steuerungseinrichtung vorteilhafter Weise so ausgelegt, dass Topografiedaten der Messeinrichtung zur individuellen Steuerung der Segmente verwendet werden können, um die definierten Abstände zwischen den einzelnen Segmenten und der Oberfläche der elektronischen Baugruppe einzuhalten.

Gemäß einer Ausführungsform der vorliegenden Erfindung besteht die Schutzeinrichtung aus einer Vielzahl individuell steuerbarer Segmente. Da die Baugruppentopografie sehr unterschiedlich sein kann, muss die Schutzeinrichtung in der Lage sein, sich an relativ kleine Topografie Details anpassen zu können. Dies wird gelöst durch eine Vielzahl individuell steuerbarer Segmente.

Um beidseitig bestückte Baugruppen bei der Öffnungssteuerung besser berücksichtigen zu können, kann die Vielzahl individuell steuerbarer Segmente in der Öffnung so angeordnet sein, dass die individuell steuerbaren Segmente bei Durchtritt der elektronischen Baugruppe durch die Öffnung oberhalb und unterhalb der elektronischen Baugruppe angeordnet sind.

In einer Ausführungsform ist die Steuerungseinrichtung so ausgelegt, dass die Steuerungseinrichtung die individuell steuerbaren Segmente so steuert, dass für jedes Segment ein definierter Abstand zwischen der elektronischen Baugruppe und dem Segment eingehalten wird, während die elektronische Baugruppe die Öffnung passiert. D. h., beim Durchlaufen der Baugruppe durch die Öffnung wird der Abstand zwischen der Baugruppenoberfläche und jedem einzelnen Segment permanent nachgeregelt, so dass die Differenz zwischen dem geregelten Öffnungsquerschnitt und dem Baugruppenquerschnitt an der aktuellen Durchlaufposition durch die Öffnung nahezu konstant klein bleibt. Selbst wenn auf einer Baugruppe auf ein sehr hohes Bauteil ein sehr niedriges Bauteil folgt, bleibt die Differenzfläche, durch die Schutzgas entweichen kann, konstant klein.

Gemäß Ausführungsformen der vorliegenden Erfindung besteht die elektronische Baugruppe aus einer Vielzahl von elektronischen Bauelementen, die auf einer Oberseite und/oder einer Unterseite einer Leiterplatte befestigt sind.

In bestimmten Ausführungsformen verwendet die Messeinrichtung bildgebende 2D und/oder 3D Messverfahren, und/oder optische Messverfahren, und/oder mechanische Messverfahren, und/oder akustische Messverfahren zur Erfassung der Topographie der elektronischen Baugruppe verwendet. Um ortsabhängige Höheninformationen der elektronischen Baugruppe zu bestimmen können beispielsweise eine oder mehrere Kameras verwendet werden, um ein dreidimensionales Modell der Baugruppe zu erstellen. Alternativ dazu oder zur Unterstützung der Auswertung der Kamerabilder können die Höheninformationen auch interferometrisch mit einem Laser oder einem Array von Lasern gewonnen werden. Alternativ und unterstützend zu den vorher genannten Verfahren können auch mechanische Tastverfahren oder akustische Verfahren wie beispielsweise Erzeugen und Auswerten eines Schallfeldes zur Gewinnung von Höheninformationen verwendet werden. Alternativ und unterstützend zu den vorher genannten Verfahren können die 2/3D-Daten der Baugruppengeometrie aus den vorherigen Prozessen wie z.B. Baugruppenentwicklung und/oder Bestückprozess übernommen werden.

In einer besonderen Ausführungsform weist die Prozesskammer weiterhin eine Vielzahl von Stelleinrichtungen entsprechend der Vielzahl von individuell steuerbaren Segmenten auf, mit der die individuell steuerbaren Segmente in vertikaler Richtung bewegt werden können. Somit können die Abstände zwischen den individuell steuerbaren Segmenten und der Oberfläche der elektronischen Baugruppe eingestellt werden. Die Stelleinrichtung kann dabei eine elektrische oder pneumatische Antriebseinrichtung umfassen.

In bestimmten Ausführungsformen sind die individuell steuerbaren Segmente aus Edelstahl gefertigt. Edelstahl ist ein inertes, robustes und zu wenig Korrosion neigendes Material, so dass solchermaßen ausgeführte Segmente wartungsarm sind und die Prozesse nicht beeinflussen. Weiterhin ist Edelstahl leitfähig und ist somit in der Lage, statische Elektrizität, die sich negativ auf elektronische Baugruppen auswirken können, abzuleiten. Da Edelstahl weiterhin sehr formstabil ist, erlauben individuell steuerbare Segmente aus Edelstahl eine präzise Positionierung relativ zur Oberfläche der elektronischen Baugruppe sowie relativ zueinander.

Alternativ dazu können die individuell steuerbaren Segmente aus einem bis 240°C stabilen und leitfähigen Kunststoff gefertigt werden wie z.B. PEEK, wenn auf die Gerätekosten geachtet werden muss.

### Kurze Beschreibung der Figuren

Die vorliegende Erfindung wird nun anhand der folgenden Figuren beschrieben, in denen
- Fig. 1: eine Querschnittsansicht einer Prozesskammer gemäß der vorliegenden Erfindung zeigt,
- Fig. 2: eine Ansicht von vorne auf eine Öffnung der Prozesskammer gemäß der vorliegenden Erfindung zeigt, und
- Fig. 3: schematisch einen Vergleich zwischen dem Stand der Technik und der vorliegenden Erfindung der Wirkungsweise eines Vorhangs zeigt.

### Ausführliche Beschreibung

Die vorliegende Erfindung betrifft eine Prozesskammer zur Durchführung thermischer Prozesse in der Fertigung elektronischer Baugruppen. Bei der Fertigung elektronischer Baugruppen sind die einzelnen Prozessschritte wie beispielsweise Beschichten, Bestückten, Löten, Lackieren, Testen etc. nicht hermetisch voneinander getrennt. Die elektronischen Baugruppen werden zwischen den einzelnen Verarbeitungsschritten auf einer Transporteinrichtung zwischen den Prozessstationen/Prozesskammern transportiert. Die Prozesskammern weisen Öffnungen auf um die elektronischen Baugruppen in die und aus der Kammer zu bringen. Der Fertigungsprozess findet also in einer offenen Umgebung statt, wodurch der Arbeitsfluss erleichtert wird. Allerdings finden die thermischen Prozesse unter einer Schutzgasatmosphäre statt, um Oxidation zu vermeiden. Dazu wird durch lokales Zuführen von Schutzgas eine lokale Schutzgasatmosphäre geschaffen. Durch den offenen Charakter der Prozessabläufe handelt es sich dabei um ein dynamisches Gleichgewicht für die Schutzgaskonzentration am Prozessort, bei dem ständig lokal so viel Schutzgas zugegeben wird, dass der Abfluss durch Öffnungen kompensiert wird. Je kleiner die Öffnungen desto weniger Schutzgas muss nachgeführt werden, um eine bestimmte Konzentration am Prozessort aufrecht zu erhalten. Die vorliegende Erfindung erfolgte, um den offenen Charakter der Prozessabläufe beizubehalten, und um die notwendigen Öffnungen möglichst klein zu halten. Dadurch wird der Verbrauch an Schutzgas verringert. Weiterhin entsteht dadurch eine stabilere Prozessumgebung und die Prozessergebnisse sind reproduzierbarer.

Um den Öffnungsquerschnitt um das Werkstück baugruppenabhängig zu reduzieren und damit den Verlust des inerten Schutzgases zu senken, wird der Öffnungsquerschnitt aktiv an die Topographie eines Werkstücks angepasst. Dazu kann zuerst die Topografie des Werkstücks mit Hilfe von 2D und/oder 3D bildgebenden, optischen, mechanischen und/oder akustischen Messverfahren bestimmt werden. Alternativ und unterstützend zu den vorher genannten Verfahren können die 2/3D-Daten der Baugruppengeometrie aus den vorherigen Prozessen wie z.B. Baugruppenentwicklung und/oder Bestückprozess übernommen werden. Auf Basis dieser Messdaten kann eine aus pneumatisch, elektrisch oder mechanisch angesteuerten Einzelelementen zusammengesetzte Vorrichtung die Topografie des Werkstückes in der Durchlaufrichtung als Negativform derart abbilden, dass die Werkstücke die Öffnung bei einem möglichst geringen Abstand passieren können.

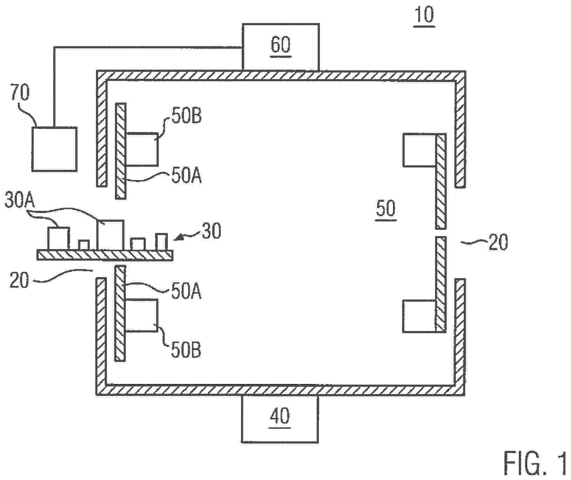

Fig. 1 zeigt schematisch eine Querschnittsansicht einer Prozesskammer gemäß der vorliegenden Erfindung. Im Querschnitt von Figur 1 bezeichnet des Bezugszeichen 10 eine Prozesskammer, das Bezugszeichen 20 eine Öffnung, das Bezugszeichen 30 eine elektronische Baugruppe, das Bezugszeichen 30A Bauelemente der Baugruppe, das Bezugszeichen 40 eine Einrichtung zum Zuführen eines Schutzgases, das Bezugszeichen 50 eine steuerbare Schutzeinrichtung, das Bezugszeichen 50A ein individuell steuerbares Segment, das Bezugszeichen 50B eine Stelleinrichtung, das Bezugszeichen 60 eine Steuerungseinrichtung und das Bezugszeichen 70 eine Messeinrichtung. In Figur 1 ist die Prozesskammer 10 mit zwei Öffnungen 20 dargestellt, die zum Einbringen bzw. Herausnehmen der elektronischen Baugruppe 30 vorgesehen sind.

In der in Figur 1 dargestellten Anordnung wird eine Baugruppe 30 in die Prozesskammer 10 eingeführt. Die Darstellung von Figur 1 zeigt einen Zustand zu einem Zeitpunkt t₁, an dem die Baugruppe 30 die Öffnung 20 des Einlasses passiert. Zu diesem Zeitpunkt t₁ hat die Steuerungseinrichtung 60 die Stelleinrichtung 50B der Schutzeinrichtung 50 bereits veranlasst, die Segmente 50A der Schutzeinrichtung 50 so weit zurückzuziehen, dass die elektronische Baugruppe 30 unter Berücksichtigung der Höhe des aktuell am Ort der Schutzeinrichtung stehenden Bauelementes 30A durch die Öffnung passt. Dabei wird ein Sicherheitsabstand zwischen dem individuell steuerbaren Segment 50A und der Oberfläche des Bauelements 30A eingehalten.

In der in Figur 1 dargestellten Anordnung passiert zum Zeitpunkt t₁ keine elektronische Baugruppe die Öffnung am Ausgang der Prozesskammer 10. Entsprechend sind die individuell steuerbaren Segmente 50 A so positioniert, dass sie die Prozesskammer 10 nahezu verschließen, bzw. eine Öffnung freilassen, die einem Sicherheitsabstand der individuell steuerbaren Segmente 50A zueinander bzw. zu angrenzenden Strukturen entsprechen.

Zu einem späteren Zeitpunkt t₂ (nicht gezeigt), zu dem sich ein nachfolgendes Bauelement 30A am Ort der Schutzeinrichtung 50 befindet, veranlasst die Steuerungseinrichtung 60 die Stelleinrichtung 50B der Schutzeinrichtung 50, die Position der Segmente 50A der Schutzeinrichtung 50 der Höhe des nachfolgenden Bauelements 30A anzupassen.

Die Höheninformationen der Bauelemente 30A kann beispielsweise mit einer Messeinrichtung 70 zu einem vorangehenden Zeitpunkt to bestimmt werden (nicht gezeigt), bevor die elektronische Baugruppe 30 die Öffnung 20 passiert. Beispielsweise kann über bildgebende Verfahren, beispielsweise mittels Kamera, ein 3D Modell der elektronischen Baugruppe 30 erstellt werden, aus dem die Höhendaten der Bauelemente 30A ausgelesen werden können. Zusammen mit Position und Geschwindigkeitsdaten der elektronischen Baugruppe 30 relativ zu Prozesskammer 10 kann die Steuerungseinrichtungen 60 berechnen, zu welcher Zeit ein bestimmtes Bauelement mit einer bestimmten Höhe an der Stelle der Schutzeinrichtung 60 die Öffnung 20 passiert. Entsprechend kann die Steuerungseinrichtung 60 die Stelleinrichtung 50B ansteuern, um die individuell steuerbaren Segmente 50A entsprechend der Höhe des Bauteils 30A zu positionieren.

Alternativ oder in Kombination kann die Höheninformation der Bauelemente 30A mit einem mechanischen Taster oder/und interferonmetrischen Sensoren unmittelbar am Eingang der Öffnung 20 ermittelt werden.

Vorzugsweise sind die individuell steuerbaren Segmente 50A aus Edelstahl gefertigt. Dadurch erhält man haltbare, formstabile und leitfähige Segmente. Korrosion und Abrieb sind gering, so dass weniger Wartung erforderlich ist. Weiterhin sorgt die Leitfähigkeit für eine Ableitung von statischer Elektrizität, die beispielsweise beim Transport auf der elektronischen Baugruppe entsteht. Eine bessere Ableitung von statischer Elektrizität lässt sich beispielsweise durch weiche leitfähige Bürsten am Ende der individuell steuerbaren Segmente erreichen, die statische Ladungen ableiten können. Da Segmente aus Edelstahl formstabil sind und sehr präzise gefertigt werden können, können Sicherheitsabstände zu Bauelementen oder anderen Teilen der Prozesskammer minimiert werden, so dass die Nettoöffnung, durch die Schutzgas entweichen kann, minimiert werden kann. Unter Nettoöffnung wird eine Nettoöffnungsfläche verstanden, durch die Schutzgas entweichen kann. Die Nettoöffnungsfläche entspricht der Differenz zwischen der durch die individuell steuerbaren Segmente verkleinerte Öffnungsfläche und der Baugruppenquerschnittsfläche. Die Nettoöffnungsfläche ergibt sich aus den Sicherheitsabständen zwischen den individuell steuerbaren Segmenten untereinander und zur elektronischen Baugruppe.

Werden geringere Anforderungen an Präzision und Minimierung von Verbrauchsmaterial und Wartung gestellt, kann auch ein leitfähiger temperaturstabiler Kunststoff als Material für die individuell steuerbaren Segmente verwendet werden, wodurch die Herstellungskosten für die Prozesskammer verringert werden können.

Als Stelleinrichtung werden vorzugsweise elektrische, elektromechanische oder pneumatische Antriebseinrichtungen verwendet. Beispielsweise könnte ein Schrittmotor mit definierter Schrittweite, ein pneumatischer Kolben mit Positionserfassung, ein Elektromotor mit Positionserfassung der individuell steuerbaren Segmente, etc. verwendet werden.

Die Steuerungseinrichtung 60 kann mit der Messeinrichtung 70 und der Stelleinrichtung 50B drahtlos oder drahtgebunden kommunizieren.

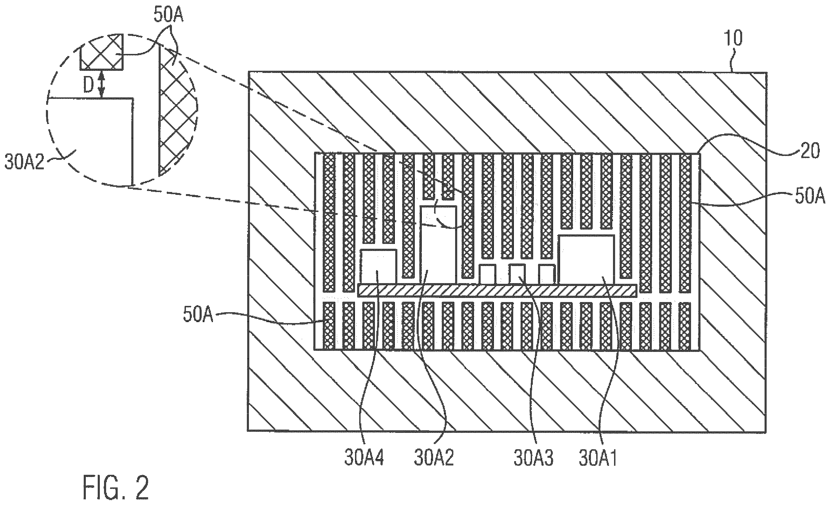

Fig. 2 zeigt eine schematische Ansicht von vorne mit Blick auf die Öffnung 20 der Prozesskammer 10 gemäß der vorliegenden Erfindung zum vorher beschriebenen Zeitpunkt t₁.

Die individuell steuerbaren Segmente 50A verkleinern die Fläche der Öffnung 20. Die einseitig mit Bauelementen 30A1, 30A2, 30A3 und 30A4 mit unterschiedlicher Höhe bestückte elektronische Baugruppe passiert die Öffnung 20. Zu diesem Zeitpunkt wurde das Höhenprofil bereits ermittelt und die entsprechenden individuell steuerbaren Segmente wurden so positioniert, dass sie der Kontur des Querschnitts der elektronischen Baugruppe an dieser Stelle folgen. In der Ausschnittvergrößerung erkennt man den Sicherheitsabstand D zwischen dem Bauelement 30A2 und dem individuell steuerbaren Segment 50 A. Zur Verbesserung der Übersichtlichkeit sind die Sicherheitsabstände nicht maßstabsgetreu sondern übertrieben dargestellt.

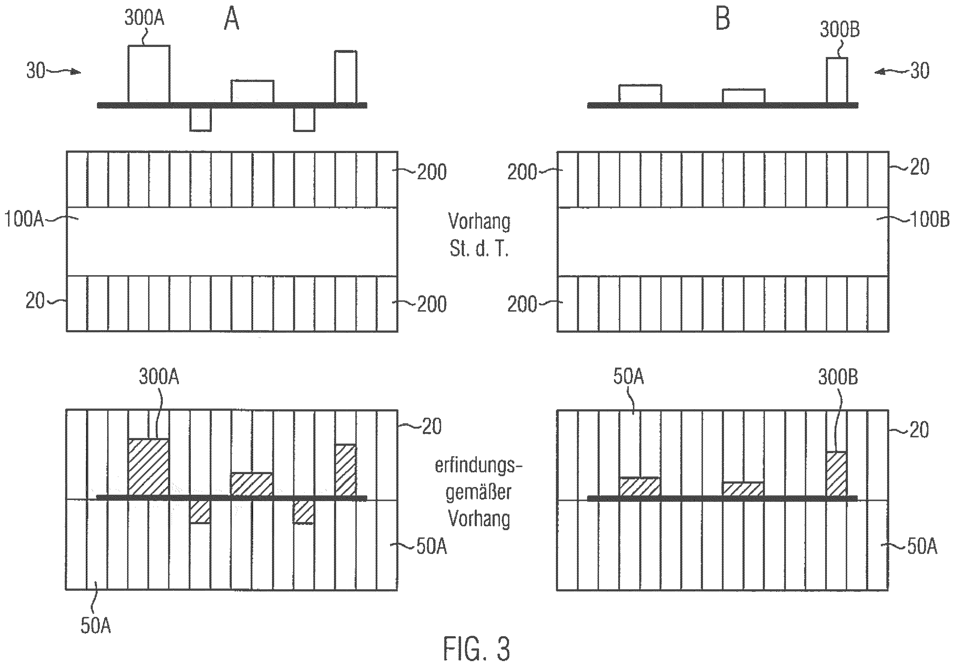

Fig. 3 zeigt schematisch einen Vergleich der Wirkungsweise einer Schutzeinrichtung zum Verringern des Entweichens von Schutzgas aus einer Prozesskammer zwischen dem Stand der Technik und der vorliegenden Erfindung. Im Stand der Technik werden solche Schutzeinrichtungen häufig als "Vorhang" bezeichnet und häufig als "Lamellenvorhang" realisiert. In der vorliegenden Erfindung wird die Schutzeinrichtung als mechatronischer Vorhang bezeichnet, da die Position der einzelnen Lamellen individuell mithilfe einer Steuerung über entsprechende Antriebe eingestellt werden kann.

Figur 3 zeigt weiterhin einen Vergleich der Vorhangsteuerung zwischen zwei unterschiedlichen elektronischen Baugruppen. Baugruppe A ist beidseitig bestückt und weist einen Umriss/Kontur 300A auf. Baugruppe B ist nur einseitig bestückt mit insgesamt niedrigeren elektronischen Bauelementen. Baugruppe B weist einen Umriss 300 B auf. Der Vorhang gemäß Stand der Technik umfasst eine Vielzahl von Lamellen 200, die die Öffnungsfläche der Öffnung 20 verkleinert. Passiert die Baugruppe A die Öffnung 20 gemäß Stand der Technik, ergibt sich eine Nettoöffnungsfläche 100A, durch die Schutzgas entweichen kann. Die Nettoöffnungsfläche 100 A ergibt sich aus der Differenz zwischen der durch den Vorhang verkleinerten Öffnungsfläche und der Fläche der Kontur 300A der Baugruppe A. Entsprechend ergibt sich eine Nettoöffnungsfläche 100B, wenn die Baugruppe B die Öffnung 20 passiert. Da die Baugruppe B nur einseitig bestückt ist und kleinere Bauteile aufweist, ist die Fläche der Kontur 300B kleiner als die Fläche der Kontur 300A. Die Nettoöffnungsfläche 100B ist größer als die Nettoöffnungsfläche 100A, so dass mehr Schutzgas entweicht, wenn Baugruppe B die Öffnung passiert. Wenn keine Baugruppe die Öffnung passiert, ist die Nettoöffnungsfläche größer als die Nettoöffnungsflächen 100A und 100B, da die Position der Lamellen 200 des Vorhangs des Standes der Technik nicht verändert werden.

Im Gegensatz dazu sind die Lamellen des erfindungsgemäßen Vorhangs individuell steuerbare Segmente 50 A, die sich der Kontur 300A/300B der jeweiligen Baugruppe A/B anpassen. Die Nettoöffnungsfläche bei einem erfindungsgemäßen Vorhang/Schutzeinrichtung 50 ist bei beiden Baugruppen nahezu gleich und wird durch den Sicherheitsabstand D der Segmente 50 A zur elektronischen Baugruppe 30 bestimmt. Somit kann baugruppenunabhängig eine Nettoöffnungsfläche, durch die Schutzgas entweichen kann, minimiert werden.

## Patentansprüche

1. Prozesskammer (10) zur Durchführung thermischer Prozesse in der Fertigung einer elektronischen Baugruppe (30), die Folgendes umfasst:
mindestens eine Öffnung (20) zum Einbringen und/oder Herausnehmen der elektronischen Baugruppe (30);
eine Einrichtung (40) zum Zuführen eines Schutzgases;
eine steuerbare Schutzeinrichtung (50), die an der Öffnung (20) angeordnet ist, um ein Entweichen von Schutzgas aus der Prozesskammer zu verringern; **gekennzeichnet durch** eine Messeinrichtung (70), die die Topografie der elektronischen Baugruppe erfasst und
eine Steuerungseinrichtung (60), die die Schutzeinrichtung (50) auf der Grundlage der Messdaten der Messeinrichtung (70) so steuert, dass, wenn die elektronische Baugruppe (30) die Öffnung (20) passiert, ein Öffnungsquerschnitt der Öffnung bereitgestellt wird, der mit der Höhe des aktuell am Ort der Schutzeinrichtung stehenden Bauelementes (30A) der elektronischen Baugruppe (30) korrespondiert.

2. Prozesskammer (10) nach Anspruch 1, wobei die Schutzeinrichtung (50) aus einer Vielzahl individuell steuerbarer Segmente (50A) besteht.

3. Prozesskammer (10) nach Anspruch 2, wobei die Vielzahl individuell steuerbarer Segmente in der Öffnung so angeordnet sind, dass sie bei Durchtritt der elektronischen Baugruppe durch die Öffnung oberhalb und/oder unterhalb der elektronischen Baugruppe angeordnet sind.

4. Prozesskammer (10) nach Anspruch 2 oder 3, wobei die Steuerungseinrichtung so ausgelegt ist, dass, die Steuerungseinrichtung die individuell steuerbaren Segmente so steuert, dass für jedes Segment ein definierter Abstand zwischen der elektronischen Baugruppe und dem Segment eingehalten wird, während die elektronische Baugruppe die Öffnung passiert.

5. Prozesskammer (10) nach Anspruch 1, wobei die Steuerungseinrichtung ausgelegt ist, Topografiedaten der Messeinrichtung zur individuellen Steuerung der Segmente zu verwenden, um die definierten Abstände zwischen den einzelnen Segmenten und der Oberfläche der elektronischen Baugruppe einzuhalten.

6. Prozesskammer (10) nach einem der Ansprüche 5 - 5, wobei die Messeinrichtung (70) bildgebende 2D und/oder 3D Messverfahren, und/oder optische Messverfahren, und/oder mechanische Messverfahren, und/oder akustische Messverfahren zur Erfassung der Topographie der elektronischen Baugruppe verwendet.

7. Prozesskammer (10) nach einem der Ansprüche 5 - 6, wobei die Messeinrichtung (70) ausgelegt ist, vorhandene 2D und/oder 3D Daten der Baugruppen zu übernehmen.

8. Prozesskammer (10) nach einem der Ansprüche 2 - 7, die weiterhin eine Vielzahl von Stelleinrichtungen (50B) entsprechend der Vielzahl von individuell steuerbaren Segmenten (50A) aufweist, mit der die individuell steuerbaren Segmente in vertikaler Richtung bewegt werden können.

9. Prozesskammer (10) nach Anspruch 8, wobei die Stelleinrichtung eine elektrische oder pneumatische Antriebseinrichtung umfasst.

10. Prozesskammer (10) nach einem der Ansprüche 2 - 7, wobei die individuell steuerbaren Segmente aus Edelstahl gefertigt sind.

11. Prozesskammer (10) nach einem der Ansprüche 2 - 7, wobei die individuell steuerbaren Segmente aus einem bis 280°C stabilen und leitfähigen Kunststoff gefertigt sind.

## Claims

1. A process chamber (10) for carrying out thermal processes in the manufacture of an electronic assembly (30) comprising:
at least one opening (20) for introducing and/or removing the electronic assembly (30);
means (40) for supplying a protective gas;
controllable protection means (50) arranged at the opening (20) to reduce escape of protective gas from the process chamber; and
**characterized by**
a measuring means (70) which detects the topography of the electronic assembly
control means (60) that controls based on the measurement data of the measuring means (70) the protection means (50) such that, when the electronic assembly (30) passes the opening (20), an opening cross section of the opening is provided, which corresponds with the height of the component (30A) of the electronic assembly (30) currently situated at the location of the protection means.

2. The process chamber (10) according to claim 1, wherein the protection means (50) consists of a plurality of individually controllable segments (50A).

3. The process chamber (10) according to claim 2, wherein the plurality of individually controllable segments are arranged in the opening such that they are arranged above and/or below the electronic assembly when the electronic assembly passes through the opening.

4. The process chamber (10) according to claim 2 or 3, wherein the control means is configured such that the control means controls the individually controllable segments such that for each segment a defined distance between the electronic assembly and the segment is maintained while the electronic assembly passes the opening.

5. The process chamber (10) according to claim 1, wherein the control means is configured to use topography data of the measuring means for individual control of the segments in order to maintain the defined distances between the individual segments and the surface of the electronic assembly.

6. The process chamber (10) according to claim 5, wherein the measuring means (70) uses imaging 2D and/or 3D measuring methods and/or optical measuring methods and/or mechanical measuring methods and/or acoustic measuring methods for detecting the topography of the electronic assembly.

7. The process chamber (10) according to one of claims 5 - 6, wherein the measuring means (70) is configured to adopt existing 2D and/or 3D data of the assemblies.

8. The process chamber (10) according to one of claims 2 - 7, further comprising a plurality of actuating means (50B) corresponding to the plurality of individually controllable segments (50A) by which the individually controllable segments can be moved in the vertical direction.

9. The process chamber (10) according to claim 8, wherein the actuating means comprises an electric or pneumatic drive means.

10. The process chamber (10) according to one of the claims 2 - 7, wherein the individually controllable segments are made of stainless steel.

11. The process chamber (10) according to one of the claims 2 - 7, wherein the individually controllable segments are made of a conductive synthetic material stable up to 280°C.

## Revendications

1. Chambre de processus (10) pour mettre en œuvre des processus thermiques dans la fabrication d'un ensemble électronique (30), comprenant les éléments suivants :
au moins une ouverture (20) pour introduire et/ou extraire l'ensemble électronique (30) ;
un dispositif (40) pour fournir un gaz de protection ;
un dispositif de protection contrôlable (50) agencé sur l'ouverture (20) pour réduire la fuite de gaz de protection hors de la chambre de processus ;
**caractérisée par**
un dispositif de mesure (70) qui enregistre la topographie de l'ensemble électronique, et
un dispositif de commande (60) qui commande le dispositif de protection (50) sur la base des données de mesure provenant du dispositif de mesure (70) de sorte que lorsque l'ensemble électronique (30) passe devant l'ouverture (20), une section transversale de l'ouverture est présentée qui correspond à la hauteur du composant (30A) de l'ensemble électronique (30) se trouvant actuellement à l'emplacement du dispositif de protection.

2. Chambre de processus (10) selon la revendication 1, dans laquelle le dispositif de protection (50) est constitué d'une pluralité de segments contrôlables individuellement (50A).

3. Chambre de processus (10) selon la revendication 2, dans laquelle les segments de la pluralité de segments contrôlables individuellement sont agencés dans l'ouverture de manière à être placés au-dessus et/ou au-dessous de l'ensemble électronique lorsque l'ensemble électronique passe à travers l'ouverture.

4. Chambre de processus (10) selon la revendication 2 ou 3, dans laquelle le dispositif de commande est conçu de manière à commander individuellement les segments contrôlables, de sorte qu'une distance définie entre l'ensemble électronique et le segment est maintenue pour chaque segment pendant que l'ensemble électronique passe à travers l'ouverture.

5. Chambre de processus (10) selon la revendication 1, dans laquelle le dispositif de commande est conçu pour utiliser les données topographiques du dispositif de mesure pour le contrôle individuel des segments afin de maintenir les distances définies entre les segments individuels et la surface de l'ensemble électronique.

6. Chambre de processus (10) selon la revendication 5, dans laquelle le dispositif de mesure (70) utilise des procédés de mesure d'imagerie 2D et/ou 3D, et/ou des procédés de mesure optique, et/ou des procédés de mesure mécaniques, et/ou des procédés de mesure acoustiques pour enregistrer la topographie de l'ensemble électronique.

7. Chambre de processus (10) selon l'une des revendications 5 et 6, dans laquelle le dispositif de mesure (70) est conçu pour accepter des données 2D et/ou 3D existantes des ensembles.

8. Chambre de processus (10) selon l'une des revendications 2 à 7, comprenant en outre une pluralité d'actionneurs (50B) correspondant à la pluralité de segments contrôlables individuellement (50A) avec lesquels les segments contrôlables individuellement peuvent être déplacés en direction verticale.

9. Chambre de processus (10) selon la revendication 8, dans laquelle le dispositif d'actionnement comprend un dispositif d'entraînement électrique ou pneumatique.

10. Chambre de processus (10) selon l'une des revendications 2 à 7, dans laquelle les segments contrôlables individuellement sont en acier inoxydable.

11. Chambre de processus (10) selon l'une des revendications 2 à 7, dans laquelle les segments contrôlables individuellement sont constitués d'un plastique conducteur et stable jusqu'à 280 °C.
